# EUROPÄISCHE PATENTANMELDUNG

(11) **EP 4 553 510 A1**
(43) Veröffentlichungstag der Anmeldung: **14.05.2025**
(21) Anmeldenummer: 24211139.1
(22) Anmeldetag: 06.11.2024
(51) Int. Cl.: G01R 31/12

(54) **COMPUTERIMPLEMENTIERTES VERFAHREN ZUR BEWERTUNG DES ZUSTANDS EINES ÜBERSPANNUNGSABLEITERS**

(30) Priorität: 10.11.2023 DE 102023131313
(71) Anmelder: Tridelta Meidensha GmbH, 07629 Hermsdorf (DE)
(72) Erfinder: Raschke, Philipp, 07629 Hermsdorf (DE); Fotsing, Sinclair Junior Jontzo, 07629 Hermsdorf (DE)
(74) Vertreter: Henkel & Partner mbB

(57) **Zusammenfassung**

Die Erfindung betrifft ein computerimplementiertes Verfahren zur Zustandsüberwachung und Bewertung des Verhaltens eines Überspannungsableiters, wobei das Verfahren die folgenden Schritte umfasst:
- Bereitstellen von Messwerten (S10) eines oder mehrer Überspannungsableiter;
- Standardisieren der bereitgestellten Messwerte (S12);
- Extrahieren von Kenngrößen (S14) zur Charakterisierung jedes Überspannungsableiters aus den standardisierten Messwerten;
- Ermitteln eines Zustands jedes Überspannungsableiters (S16) unter Verwendung eines Algorithmus des maschinellen Lernens; und
- Ausgabe einer Handlungsemfehlung für den Betrieb jedes Überspannungsableiters (S18) des Überspannungsableiters aus dem ermittelten Zustand.

## Beschreibung

Die Erfindung betrifft ein Verfahren zur Bewertung von Zuständen von Überspannungsableitern anhand ihres Kriech- und Leckstroms.

Ein Überspannungsableiter, auch als Überspannungsschutzeinrichtung bezeichnet, wird in elektrischen Energieübertragungs- und -verteilungssystemen eingesetzt, um an diese Systeme angeschlossene Geräte vor Schäden durch Überspannungen durch Blitzeinwirkung oder Schaltvorgänge im Netz zu schützen.

In der Regel verwendet ein Überspannungsableiter Varistoren, um seine Funktion zu erfüllen. Varistoren sind Bauteile aus Zink-Oxid mit nicht linearer elektrischer Widerstandseigenschaft. Das bedeutet, dass ihr Widerstand beim Überschreiten eines Schwellwerts sprunghaft abnimmt. Diese Eigenschaft ermöglicht es dem Überspannungsableiter, die Überspannung schnell und effektiv zur Erde zu leiten. Der Überspannungsableiter ist dazu in der Regel zwischen Leiter und Erde verbunden. Im Falle einer Überspannung leitet der Überspannungsableiter die überschüssige Energie sicher zur Erde ab und begrenzt dadurch die Netzspannung auf einen Wert, der die Isolationswerte des angeschlossenen Energietechnik nicht überschreitet, während er die Leitungen bei normalen Betriebsspannungen von der Erde isoliert.

Überspannungsableiter werden so ausgelegt, dass sie im normalen Betrieb unterhalb ihrer sogenannten maximalen dauerhaften Betriebsspannung (U_{c}) betrieben werden und damit ein hochohmiges Verhalten aufweisen, wodurch nur ein kleiner sogenannter Leckstrom durch den Aktivteil des Überspannungsableiters fließt. Überspannungsableiter sind in der Regel so dimensioniert, dass der Leckstrom im normalen Betrieb keine zu große Verlustleistung verursacht oder einen gewissen Grenzwert nicht überschreitet.

Allerdings kann eine kurzzeitige oder kontinuierliche Überlastung des Überspannungsableiters, eine fehlerhafte Konstruktion der Feldsteuerelemente oder die Verwendung von nicht langzeitstabilen Zink-Oxid Varistoren zu einer Degradation der Varistoren führen, wobei sich die U-I-Kennlinie des Überspannungsableiters sprungartig oder auch sukzessiv absenkt und im neuen Arbeitspunkt damit ein höherer Leckstrom fließt. Die Verlustleistung wird in Form von Wärmeenergie vom Überspannungsableitergehäuse ausgestrahlt. Wenn die durch kontinuierlichen Leckstrom und durch zusätzliche transiente Überspannungen in den Ableiter eingetragene Elektrische Energie die vom Ableiter nach außen abstrahlbare Wärmeenergie überschreitet, wird dieser thermisch instabil und versagt elektrisch. Dies ist ein Fehlerfall, der nur selten auftritt.

Die meisten Ausfälle von Überspannungsableitern sind auf das Eindringen von Feuchtigkeit zurückzuführen. Ein solches Eindringen erfolgt in der Regel entweder durch defekte Dichtungssysteme bei Überspannungsableitern mit Gasvolumen oder, wie es bei direkt umgossenen Polymerableitern oder anderen Ableitern ohne Gasvolumen der Fall ist, direkt durch die Grenzschicht zwischen den unterschiedlichen Materialien. Die möglichen Ursachen für einen solchen Ausfall sind beispielsweise Fehler bei der Herstellung des Produkts, Materialermüdung, oder konstruktive Schwachstellen. Bei Überspannungsableitern mit eingeschlossenem Gasvolumen ist es in der Regel ein langwieriger Prozess, bei dem die Feuchtigkeit aufgrund von einem alternierenden Druckunterschied zwischen dem Innen- und Außenraum des Überspannungsableiters durch eine Leckage in das Innere gelangt. Wenn die Temperatur im feuchten Innenraum den Taupunkt unterschreitet, kondensiert Feuchtigkeit entlang des Aktivteils oder entlang des inneren Überspannungsableitergehäuses. Dies kann zu Überschlägen und einer Kriechstrombildung im Inneren des Gehäuses führen, was schlussendlich zu einem vollständigen Kurzschluss im Inneren und dadurch zum schlagartigen Versagen des Ableiters führen kann.

Eine weitere häufige Ausfallart ist eine durch Oberflächenverschmutzung verursachte Verschlechterung des Isolationsvermögens des Ableitergehäuses in Form von erhöhter Oberflächenleitfähigkeit, Kriechspurbildung und Erosion. Dies ist ein häufiges Problem bei Überspannungsableitern, die in sogenannten Verschmutzungsgebieten eingesetzt werden. Diese Überspannungsableiter weisen nach einer gewissen Zeit Ablagerungen von leitfähigen Sedimenten auf. Dadurch bilden sich Kriechwegströme und zunächst partielle Überschläge entlang der Gehäuseoberfläche, die das Gehäuse des Überspannungsableiters beschädigen können oder die Hydrophobieeingenschaften von Silikonisolierten Überspannungsableitern verschlechtern. Außerdem kann durch nur teilweise leitfähige Gehäuseabschnitte ein hohes radiales Feld zwischen Varistorsäule und der äußeren Verschmutzungsschicht entstehen und Teilentladungen und damit Beschädigungenim Gehäuseinneren verursachen. Wenn diese Kontamination frühzeitig erkannt wird, kann sie durch Reinigen der Oberfläche behoben werden. Andernfalls könnte die Verschmutzung zu einem äußeren Überschlag und einer dauerhaften Beschädigung des Überspannungsableiters führen.

Unter Berücksichtigung der vielfältigen Fehlerursachen im Betrieb von Überspannungsableitern stehen die Betreiber von energietechnischen Anlagen vor der Herausforderung, mit alternden Geräten umzugehen. Dadurch rückt die Thematik "Asset Life Cycle Management" in den Fokus der Energiebranche. Um dieser Herausforderung zu begegnen, bieten Hersteller von energietechnischen Geräten Überwachungssysteme an, welche speziell für deren Produkte entwickelt worden sind. Beispielsweise offenbart DE 10 2015 013 433.7 ein derartiges Überwachungssystem für Überspannungsableiter. Ein ähnliches Konzept wird in:
https://p3.aprimocdn.net/siemensenergy/fb8f300d-debc-415c-87e6-b03b01315915/Sensarrester-flyer-with-Frost-Sullivan-Award-pdf Original%20file.pdf
gezeigt.

Diese Überwachungssysteme überwachen eine Mehrzahl von Geräten, wie beispielsweise Transformatoren, Schalter, Trenner, Wandler, Leitungen, Isolatoren und Überspannungsableiter, was zu einer großen Ansammlung an Daten führt. Diese Daten sind jedoch in der Regel so abstrakt, dass es erforderlich wird, für jedes Einsatzgebiet einen Spezialisten für deren Auswertung zu haben.

Die große Menge an Daten und Erfahrungen, insbesondere die Messdaten von Überspannungsableitern erfordern eine sorgfältige Bewertung, da der Informationsgehalt nicht ohne Weiteres ersichtlich ist. Viele Betreiber von energietechnischen Anlagen sind daher nicht in der Lage, den Zustand oder die verbleibende Lebensdauer solcher Geräte zu beurteilen.

Erschwerend kommt hinzu, dass ein Betreiber eines Energienetzes für gewöhnlich eine große Zahl von Überspannunsgableitern unterschiedlichster Bauart, verschiedenster Baujahre und von unterschiedlichen Herstellern verwendet. Einen Überblick über verschiedene grundlegende Bauweisen findet sich etwa in:
https://cache.industry.siemens.com/dl/files/132/109747132/att 918329/v1/Metalloxid-Ableiter in Hochspannungsnetzen - Grundlagen.pdf.

Bekannte Bewältigungsstrategien erfordern, dass Alarmierungen in bestehende Systeme integriert werden, welche bei Überschreitung der typischen Leckstromgrenzen des Überspannungsableiters Benachrichtigungen verschicken. Für komplex auftretende Muster jedoch, die Prognosen zu künftigen Fehlern ermöglichen könnten, muss sich der Betreiber an einen Spezialisten wenden, um manuelle Auswertungen über den Zustand des Überspannungsableiters zu beauftragen.

Vor diesem Hintergrund ist die Aufgabe der Erfindung, ein Verfahren vorzuschlagen, mit dem die gesammelten Daten genutzt werden können, um Betriebszustände automatisch zu bewerten, um das weitere Verhalten von Überspannungsableitern besser vorauszusagen zu können, rechtzeitig zu Wwarten oder auszutauschen und eine Beschädigung oder einen plötzlichen Ausfall aufgrund eines Defekts eines Überspannungsableiters zu verhindern.

Die Aufgabe wird gelöst durch die Gegenstände der unabhängigen Ansprüche.

Gemäß einem ersten Aspekt der Erfindung wird diese Aufgabe gelöst durch ein computerimplementiertes Verfahren zur Einschätzung des Betriebszustands eines Überspannungsableiters, wobei das Verfahren die folgenden Schritte umfasst:
Bereitstellen von Messwerten zumindest eines Überspannungsableiters;
Standardisieren der bereitgestellten Messwerte;
Extrahieren von Kenngrößen zur Charakterisierung des zumindest einen Überspannungsableiters aus den standardisierten Messwerten;
Ermitteln eines Zustands des zumindest einen Überspannungsableiters unter Verwendung eines Algorithmus des maschinellen Lernens;
Ausgeben einer Handlungsempfehlung für den Betrieb des zumindest einen Überspannunsgableiters.

Bei den Messwerten, etwa dem Spitzenwert des Leckstroms und/oder dem auf der dritte Harmonischen des Leckstroms basierenden resistiven Stroms, kann es sich vorzugsweise um segmentierte Zeitreihen handeln, die an einem Überspannungsableiter unter Verwendung eines entsprechenden Sensors, insbesondere einem Strommessgerät, ermittelt werden. Die so gewonnenen Daten in den gemessenen Zeitreihen können besonders bevorzugt in angemessenen Fenstern segmentiert werden, um später für eine fensterbasierte Analyse verwendet zu werden.

Die Messwerte der verschiedenen Überspannungsableiter können unterschiedliche Größenordnungen haben, was auf den überwachten Überspannungsableiter und den jeweiligen Anwendungsfall zurückzuführen ist. Für eine bessere Interpretierbarkeit und Vergleichbarkeit der Daten werden die Signale standardisiert. Zur Standardisierung kann beispielsweise eine z-Scope-Standardisierungsmethode verwendet werden, mit der die Messwerte auf eine Verteilung mit einem Mittelwert von 0 und einer Standardabweichung von 1 transformiert werden. Das dynamische Verhalten der Daten bleibt dabei erhalten, die Einheit wird dimensionslos.

Unter Umständen kann der Standardisierung eine Normalisierung vorausgehen. Der Hauptunterschied zwischen Normalisierung und Standardisierung besteht darin, dass bei der Normalisierung die Daten auf eine bestimmte Skala gebracht werden. Das Ziel dieser Methode ist es, die Daten so anzupassen, dass die Daten den gleichen Wertebereich haben. Dies ermöglicht den Vergleich zwischen Daten mit unterschiedlichen Skalen oder Einheiten.

Die Standardisierung hingegen transformiert die Daten auf eine Standardnormalverteilung. Dadurch wird der Mittelwert entfernt und die Daten auf die Einheitsvarianz skaliert. Das Ziel der Standardisierung ist es, die Daten in eine standardisierte Form zu bringen, die es ermöglicht, den Bereich der Daten beizubehalten und eine gleiche Verteilung der Werte zu haben. Dadurch werden die Messwerte unterschiedlicher Überspannungsableiter untereinander vergleichbar.

Aus den standardisierten Daten werden dann Kenngrößen extrahiert, anhand derer sich das Verhalten des Überspannungsableiters bewerten lässt. Mithilfe von diversen Methoden zur Extraktion von Merkmalen kann leicht eine große Anzahl von Merkmalen erhalten werden, die Vorteile und Nachteile mit sich bringen. Einerseits erhöht sich durch eine hohe Anzahl der verwendeten Merkmale die Genauigkeit und Tiefe der Analyse. Andererseits können die verschiedenen Merkmale häufig redundante Informationen enthalten, was sich negativ auf das Anlernen von Lernalgorithmen auswirken kann. Die Modelle können dadurch instabil werden.

Entsprechend der verschiedenen Muster in den Messwerten, können verschiedene Merkmale aus den Messwerten extrahiert werden. Die in den Messwerten gefundenen Muster können grob in wetterbedingte Signalmuster, netzbedingte Muster und Überspannungsableiterfehlverhalten unterteilt werden. Wetterbedingte und netzbedingte Muster sind unerheblich für die Auswertung des Ableiterzustands.

Im Falle einer Netzunterbrechung aufgrund von Ausfällen oder Wartungsarbeiten weisen die Leckstromwerte in der Regel einen Wert nahe 0 µA auf. Wenn ein Erdschluss in einem Netz mit isoliertem Nullleiter (Sternschaltung) auftritt, wird die betroffene Leitung auf nahezu Erdpotenzial gezogen, wodurch die Spannung am Überspannungsableiter erheblich abfällt und der Leckstrom sich verringert.

Die beiden anderen Phasen des Netzes nehmen den verketteten Spannungswert an, was zu einem Anstieg des Leckstroms führt, wie es ebenso beispielsweise bei wetterbedingten Signalmustern zu beobachten ist. Die Überspannungsableiter sind in der Regel im Freien installiert und werden von verschiedenen Wetterbedingungen wie Regen, Nebel, Feuchtigkeit und Sonneneinstrahlung beeinflusst. Beide Phänomene zeigen ähnliche Muster in den Messwerten, sind aber nicht abhängig vom Zustand des Ableiters und müssen bereits vor der Extraktion der Merkmale von den Nutzdaten getrennt werden.

Die Überspannungsableiter mit Fehlverhalten zeigen je nach Art und Ausprägung des Fehlers unterschiedliche Muster auf. Das Fehlverhalten kann beispielsweise in stark periodisch pulsierte Signalmuster, sehr stark stochastisch schwankende Signalmuster oder einen Trendanstieg des Signals unterteilt werden.

Das Hauptziel der Extraktion von Kenngrößen besteht darin, die große Datenmenge durch wenige aussagekräftige extrahierte Kenngrößen zu ersetzen, die alle notwendigen Informationen zur Lösung des untersuchten Problems enthalten. Aus der verfügbaren Datenbasis werden daher die Kenngrößen extrahiert, die den Überspannungsableiter am besten charakterisieren.

Sind die Kenngrößen für den Überspannungsableiter ermittelt, wird daraus ein Zustand des Überspannungsableiters ermittelt. Dazu wird ein Algorithmus des maschinellen Lernens verwendet.

Ein Algorithmus des maschinellen Lernens kann verschiedene Formen annehmen, wie lineare Modelle, Entscheidungsbäume, Support Vector Machines, neuronale Netzwerke und viele andere. Er wird durch das Lernen aus Trainingsdaten optimiert, indem er Muster und Regeln erkennt, um die bestmöglichen Vorhersagen oder Klassifizierungen für neue Daten zu treffen.

Die Effektivität eines Algorithmus des maschinellen Lernens hängt von verschiedenen Faktoren ab, darunter sind die Qualität und Menge der Trainingsdaten, die Wahl des Modells, die Modellkonfiguration und die Bewertung des Modells anhand von Evaluationsmetriken. Das Modell kann kontinuierlich verbessert und optimiert werden, um die Genauigkeit und Leistung zu maximieren.

Das Modell der linearen Regression nimmt eine lineare Beziehung zwischen einer abhängigen Variable und einer oder mehreren unabhängigen Variablen an und wird verwendet, um Vorhersagen zu kontinuierlichen Werten zu treffen.

Support Vector Machines (SVM) sind ein Modell, das häufig zur Klassifizierung oder Regression verwendet wird und Muster in den Daten erkennt. Es sucht nach der optimalen Trennung zwischen verschiedenen Klassen oder versucht, eine kontinuierliche Funktion an die Daten anzupassen.

Entscheidungsbäume sind Modelle, die Entscheidungsregeln in Form eines Baumdiagramms erstellen. Sie dienen dazu, Daten nach Merkmalen zu unterteilen und Vorhersagen oder Klassifizierungen zu ermöglichen.

Naive Bayes ist ein probabilistisches Modell, das auf dem Bayes-Theorem basiert und zur Klassifizierung verwendet wird. Es geht davon aus, dass Merkmale unabhängig voneinander sind, und berechnet die Wahrscheinlichkeit einer bestimmten Klasse basierend auf den gegebenen Merkmalen.

Neuronale Netzwerke betreffen Modelle, die bevorzugt für die Verarbeitung von Bildern oder anderen gitterbasierten Daten verwendet werden. Die Architektur eines neuronalen Netzwerks umfasst mehrere Knoten, Neuronen oder Nodes, die in Schichten angeordnet sind. Mehrere Schichten können ferner als Unternetzwerke ausgebildet sein. Unternetzwerke können sich ferner eine oder mehrere Schichten teilen, um ihre Aufgaben mit den gleichen Ausgangswerten zu lösen. Danach kann jedes Unternetzwerk eigene Schichten besitzen, die nur der Lösung der spezifischen Aufgabe des Unternetzwerks dienen.

Vorzugsweise werden für die Ausführung des vorgeschlagenen Verfahrens Algorithmen des maschinellen Lernens verwendet, die auf Clustering-Verfahren basieren. Beim Clustering werden die Daten in Gruppen eingeteilt, die sich am ähnlichsten sind. Dies kann insbesondere ein Modell sein, dass eine partitionierende Clusteranalyse durchführt. Diese zielt darauf ab, dass die Daten des Trainingsdatensatzes in eine von Beginn an festgelegte Anzahl an Gruppen aufgeteilt werden. Diese Aufteilung wird so lange iterativ optimiert, bis eine Zielfunktion, wie der mittlere quadratische Fehler, ein Optimum erreicht. Die verbreiteten Methoden dieser Form sind beispielsweise das K-means-, K-medoids- und CLARANS-Verfahren.

Aus dem Zustand des Überspannungsableiters kann eine Empfehlung für den weiteren Betrieb des Ableiters abgeleitet werden. Ein Überspannungsableiter, der beispielsweise in eine Klasse eingeteilt wird, die eine starke Verwitterung repräsentiert, kann beispielsweise als wenig zuverlässig eingestuft werden. Der Betreiber kann den Überspannungsableiter dann warten, reparieren oder austauschen, um einen Schaden oder einen ungeplanten Ausfall des Überspannungsableiters zu verhindern. In einem anderen Fall kann ein Überspannungsableiter beispielsweise in eine klare Fehler Klasse eingeteilt werden, wobei die Ausprägung oder Schwere des Fehlers nur gering ist, sodass die Wahrscheinlichkeit für einen Ausfall ebenso gering ist. Für den Betreiber ergeben sich hieraus keine direkten Handlungsableitungen und der Überspannungsableitung kann weiter im Betrieb bleiben.

Vorzugsweise lassen sich Überspannungsableiter in unterschiedliche Klassen einteilen, die wetterbedingten Zuständen, nutzungsbedingten Zuständen und Fehlerzuständen zugeordnet sind. In Ausführungsformen können weitere Unterklassen verwendet werden, um den Grad des jeweiligen Zustands näher zu beschreiben.

In einer Ausführungsform geht dem Standardisieren der bereitgestellten Messwerte ein Glätten der bereitgestellten Messwerte voraus.

Das Glätten der Messwerte bewirkt in vorteilhafter Weise, dass der Einfluss von Extremwerten auf die restlichen Messwerte minimiert wird.

In einer Ausführungsform geht dem Standardisieren der bereitgestellten Messwerte ein Entfernen der "Aus-Zustände" aus den bereitgestellten Messwerten voraus.

Die Aus-Zustände zeigen die Zeiträume, in denen die Leitungen spannungsfrei sind oder es zu einem Erdungsfehler gekommen ist, wodurch der Leckstrom nahezu 0 ist. Diese geringen Werte können beispielsweise mithilfe der sogenannten "Box-Plot"-Methode identifiziert und aus den Messwerten entfernt werden.

Aus den Messwerten der Aus-Zustände kann keine Information bezüglich des Zustands des Überspannungsableiters erlangt werden. Die Messwerte um die Aus-Zustände zu reduzieren, verringert daher den Rechenaufwand für den Algorithmus des maschinellen Lernens und erhöht die Effizienz, mit der die Kenngrößen ermittelt werden.

In einer Ausführungsform werden die Messdaten durch Messen des Leckstroms im Überspannungsableiter erfasst, wobei aus dem Leckstrom ein Spitzenstrom und ein resistiver Strom ermittelt werden.

Der Leckstrom in einem Überspannungsableiter besteht aus einer sinusförmigen kapazitiven Komponente, welche um -90° zum Spannungssignal phasenverschoben ist, und einer resistiven Komponente, welche zum Spannungssignal phasengleich und in Form eines periodischen Impulssignals ist.

Diese beiden Komponenten überlagern sich zu einem gesamten Leckstrom, wobei zwei wichtige Kerngrößen aus dem Leckstrom extrahiert werden können. Der Spitzenwert des Leckstroms und die dritte Harmonische bezogen auf die Netzfrequenz von 50 oder 60 Herz. Der Spitzenwert des Leckstroms richtet sich immer nach der überwiegenden Stromkomponente, kapazitiv oder resistiv. Bei niedrigen Spannungsbelastungen (U < U_{c}) nimmt der Spitzenstrom den Spitzenwert der kapazitiven Komponente an. Bei höheren Spannungsbelastungen, hauptsächlich oberhalb der Nennspannung (Uᵣ) orientiert sich der Spitzenstrom am Spitzenwert der resistiven Komponente.

Der resistive Strom ist für die Bewertung des Überspannungsableiters im Verhältnis zum kapazitiven Strom besonders aussagekräftig, da dieser sich empfindlich bei einer Verschlechterung der Stromspannungskennlinie des Überspannungsableiters verändert. Dabei verändert sich in einem solchen Fall der kapazitive Strom nicht signifikant.

Für eine optimale Überwachung des Zustands eines Überspannungsableiters ist es jedoch vorteilhaft, beide Komponenten des Leckstroms im Überspannungsableiter zu überwachen.

Eine Methode zur Messung des Leckstroms beruht darauf, dass durch die nicht lineare Stromspannungskennlinie des Überspannungsableiters Oberschwingungen im Leckstrom erzeugt werden. Der Anteil an Oberschwingungen im Leckstrom hängt stark von dem Scheitelwert des resistiven Stroms und dem Arbeitspunkt ab und variiert somit mit der Spannung und der Temperatur des Überspannungsableiters. Erfahrungsgemäß lässt sich der resistive Strom durch die dritte Harmonische mittels eines Faktors beschreiben. Beispielsweise kann der Gesamt-Leckstrom periodisch - etwa einmal pro Stunde - aus den Messwerten über 10 Wellenlängen bei der üblichen Netzspannung von 50 oder 60 Herz gewonnen werden.

Für die Auswertung des resistiven Stroms ist die dritte harmonische Oberwelle, die gebräuchlichste. Diese bietet die beste Messempfindlichkeit.

In vorteilhafter Weise bildet der Leckstrom mit den Komponenten Spitzenstrom und resistivem Strom eine relativ einfach zu bestimmende Messgröße, aus der gute Kenngrößen ableitbar sind.

In einer Ausführungsform umfasst das Extrahieren der Kenngrößen eine Transformation der standardisierten Messwerte in ein Frequenzspektrum, wobei die Kenngrößen diskrete Spektralanteile aus dem Frequenzspektrum und einen Trend des Frequenzspektrums umfassen.

Wellenförmige Daten können im Zeitbereich, im Frequenzbereich und im Zeit-Frequenzbereich analysiert werden. Jeder dieser Ansätze bietet unterschiedliche Einblicke und ermöglicht es, verschiedene Aspekte der Daten zu untersuchen.

Die Analyse im Zeitbereich betrachtet die Messwerte direkt in ihrem zeitlichen Verlauf. Dabei wird das Signalverhalten anhand von Parametern wie Muster, Trend, Periodizität und anderen wichtigen Signaleigenschaften wie Stationarität oder Nicht-Stationarität untersucht. Während stationäre Signale durch die unveränderlichen statistischen Eigenschaften, wie Mittelwert, Varianz und Autokorrelation, im Laufe der Zeit gekennzeichnet sind, ändern sich die statistischen Eigenschaften eines nicht stationären Signals mit der Zeit.

Viele Verfahren der Zeitreihenanalyse sind nur für stationäre Messreihen geeignet. Die Signale, die mittels des vorgeschlagenen Verfahrens analysiert werden, sind unter Umständen jedoch nicht stationär, da die überwachten Überspannungsableiter vielen äußerlichen Einflüssen ausgesetzt werden, welche Auswirkung auf ihre Signalmuster haben.

Nichtstationäre Signale können durch eine fensterbasierte Betrachtung als stationär behandelt werden. Die Anwendung von speziellen Verfahren kann die Signale in stationäre Signale umwandeln. Die Analyse im Zeitbereich ist besonders geeignet, um Muster oder Änderungen im dynamischen Verhalten der Messwertfolge über in Abhängigkeit von der Zeit zu erkennen. So ist es etwa möglich, punktuelle Anomalie oder Schwellenwertänderung zu identifizieren.

Beispielsweise ist das Verhalten eine Überspannungsableiters vom Tagesverlauf beeinflusst, also den Temperaturunterschieden zwischen Tag und Nacht.

Die Frequenzbereichsanalyse betrachtet die Frequenzkomponenten einer Zeitreihe, indem sie das Signal in seine spektralen Inhalte zerlegt. Hierbei werden die Amplituden, Phasenbeziehungen und Hauptfrequenzen des Signals analysiert.

Es gibt Methoden, um Signale vom Zeitbereich in den Frequenzbereich und umgekehrt zu transformieren. Die schnelle Fourier-Transformation FFT) ist eine häufig verwendete Methode. Diese Methode ermöglicht die Untersuchung der frequenzspezifischen Energie- und Phasendynamik eines Signals oder kann als Hilfsmittel für verschiedene Filter- oder Faltungsalgorithmen verwendet werden.

Die FFT eignet sich gut für stationäre Signale, da die relevanten Merkmale des Signals im Zeitbereich abgeleitet werden können. Nichtstationäre Signale haben Leistungsspektren, die schwer zu interpretiert sein können, wofür speziell die klassische Funktion der FFT stark eingeschränkt ist. Die Welch-Methode hingegen teilt das nichtstationäre Signal in aufeinanderfolgende Fenster, bildet die Fourier-Transformation für jedes Fenster und führt die Mittelwertbildung der Leistungsspektren durch.

Dadurch, dass die Messwerte von unterschiedlichen Überspannungsableitern komplizierte Signale umfassen können, deren dynamisches Verhalten sich im Laufe der Zeit aufgrund von auftretenden Fehlerzuständen oder Wettereinflüssen komplett verändert, ist eine ausschließliche Betrachtung im Zeitbereich nicht immer ausreichend. Zur Ergänzung können daher Methoden implementiert werden, welche das gesamte dynamische Verhalten und infolgedessen ihre Veränderungen erfassen. Die FFT und die DWT sind geeignete Verfahren, um dieses dynamische Verhalten im Frequenzraum abzubilden.

Zur Charakterisierung von Überspannungsleitern können insbesondere ein diskreter Spektralanteil mit 1/Tag und/oder mit 2/Tag oder eine Woche im Spitzenstrom verwendet werden. Auch Jahreszeitliche Betrachtungen über längere Zeiträume sind möglich.

Eine Betonung des Spektralanteils von 1/Tag zeugt von einem Zusammenhang mit täglichen Verläufen, beispielsweise Betauung am Morgen sowie die dadurch entstehenden hohen Oberflächenströme. Oberflächenströme sind regelmäßig durch Feuchtigkeit bedingt und wachsen mit der Verschmutzungsschicht. Außerdem kann ein normaler Betriebszustand auch durch das 1/T Verhalten geprägt sein, weil die Netzspannung meist einen ähnlichen lastabhängigen Tagesverlauf nimmt.

Der diskrete Spektralanteil mit 2/Tag im Spitzenstrom kann von einem Zusammenhang mit täglichen Verläufen, beispielsweise Verschmutzung und der Betauung am Morgen sowie der Kondensation am Abend und den dadurch ausgelösten hohen Oberflächenstrom zeugen.

Ferner können höhere Harmonische der genannten diskreten Spektralanteile des Spitzenstroms verwendet werden. Diese höheren Harmonischen können saisonales wiederkehrendes Verhalten beispielsweise im Tagesverlauf abbilden. Liegt dabei kein Rauschen in höheren Spektralbereichen und dadurch auch kein stochastisches Verhalten, also ein 1/f Verhalten vor, kann dies als das Vorhandensein von wiederkehrenden Umwelteinflüssen, die an eine Uhrzeit gekoppelt sind, interpretiert werden, etwa starke Regenfälle in Monsungebieten oder ähnliches.

In einer Ausführungsform wird eine Gegenüberstellung der Signalenergie in einem oder mehreren niedrigen Frequenzbereichen der Messwertreihe gegen ein oder mehrere höhere Frequenzbereiche vorgenommen und somit ermittelt, ob Stochastisches Verhalten vorliegt oder nicht.

In einer Ausführungsform umfassen die Kenngrößen ferner ein Signal-zu-Rauschverhältnis im Frequenzspektrum, insbesondere in einem definierten Abschnitt des Frequenzspektrums.

In einer Ausführungsform umfassen die Kenngrößen ferner einen Trend des Frequenzspektrums.

Eine Steigung im Bereich m ≈ 0 im Spektrum kann sich zeigen, wenn das Signal stochastisch verrauscht ist und alle Spektralkomponenten etwa gleich gewichtet sind. Dieses Verhalten kann insbesondere dann bei Überspannungsableitern beobachtet werden, die Feuchtigkeit im Inneren haben. Das liegt daran, dass kleine leitfähige Pfade entstehen, die aufgrund des hohen Stromflusses gleich wieder abtrocknen und das verdampfte Wasser sich an anderer Stelle niederschlägt.

In einer Ausführungsform umfassen die Kenngrößen ferner einen Trend im Zeitbereich.

Ein steigender Trend m > 0 im Zeitbereich zeigt eine sich verstärkende Dynamik im Signal oder einen kontinuierlichen Anstieg des Spitzenstroms und des resistiven Stroms an. Alle Fehlerarten können sich im Zeitbereich mit steigendem Trend äußern. Ein steigender Trend ist daher ein Anzeichen für das Vorliegen eines Fehlers. Diese Kenngröße ist jedoch weniger geeignet, um einen speziellen Fehler zu identifizieren. Davon ausgenommen kann jedoch eine fortgeschrittene Alterung des Überspannungsableiters sein, weil hierbei die Werte kontinuierlich anschwellen und das Signal wenig Energie hat.

In einer Ausführungsform umfassen die Kenngrößen ferner einen Korrelationswert zwischen dem Spitzenstrom und dem resistiven Strom im Zeitbereich.

Die Erfinder haben experimentell festgestellt, dass die Korrelation zwischen dem Spitzenstrom und dem resistiven Strom sowie die Analyse dieser beiden Signale im Frequenzbereich, zielführend war, um den Zustand des Überspannungsableiters zu identifizieren.

Die Korrelation zwischen dem Spitzenstrom und dem resistivem Strom ist groß, wenn starke Oberflächenströme auftreten. Der aus den dritten harmonischen Leckstromkomponenten extrahierte resistive Anteil des Leckstroms steigt gleichermaßen, da durch kurzzeitige Trockenband-Entladungen harmonische Anteile zum Strom hinzugefügt werden. Dies gilt allerdings auch für innere Ströme durch Feuchtigkeitseintritt, bei denen partiell trockene Flächen überschlagen. Die daraus resultierenden partiellen Kurzschlüsse der Varistorblöcke erzeugen hohe Spitzen im resistiven Strom, die den kapazitiven Stromanteil übersteigen und damit den Spitzenstrom bestimmen. Eine starke Korrelation zwischen dem resistiven Strom und dem Spitzenstrom, insbesondere größer als 0,5, kann eine starke Verschmutzung oder einen starken Feuchtigkeitseintritt bedeuten. Bei einer geringen Korrelation, insbesondere nahe 0, kann auf keine oder nur leichte Oberflächenverschmutzung oder das Fehlen von Fehlverhalten geschlossen werden.

Die Bestimmung des Korrelationskoeffizients zwischen dem Spitzenstrom und dem resistiven Strom im segmentierten Fenster verwendet werden. Beispielsweise kann hierfür der Pearson-Korrelationskoeffizient verwendet werden.

Die beschriebenen Kenngrößen lassen sich vorzugsweise gemeinsam und/oder in Gruppen verwenden.

In einer Ausführungsform wird der Leckstrom im Betrieb des Überspannungsableiters ermittelt.

In vorteilhafter Weise wird dadurch ermöglicht, dass die Überspannungsableiter, vorzugsweise in regelmäßigen Abständen, auf Fehlverhalten untersucht und entsprechend der Bewertung gewartet, repariert oder ausgetauscht werden. Die Überspannungsableiter können dazu mit Geräten ausgestattet sein, die die Messwerte an ein zentrales Auswertungssystem übermitteln.

In einer weiteren Ausführungsform können die Messwerte über einen definierten Zeitraum gesammelt und anschließend gebündelt ausgewertet werden. Hierdurch kann die kontinuierliche Übertragung der Messwerte an das zentrale Auswertungssystem auf einige wenige, beispielsweise den Transport von Datenträgern gestützte, Übertragungen beschränkt werden.

In einem weiteren Aspekt betrifft die Erfindung ein Computerprogramm mit Programmcode, um ein Verfahren wie voranstehend beschrieben auszuführen, wenn das Computerprogramm auf einem Computer ausgeführt wird.

In einem weiteren Aspekt betrifft die Erfindung einen computerlesbaren Datenträger mit Programmcode eines Computerprogramms, um ein Verfahren wie voranstehend beschrieben auszuführen, wenn das Computerprogramm auf einem Computer ausgeführt wird.

In einem weiteren Aspekt betrifft die Erfindung ein System zur Bewertung eines Verhaltens eines Überspannungsableiters, wobei das System ausgebildet ist, ein Verfahren wie voranstehend beschrieben auszuführen.

Das System kann beispielsweise als Webserver mit einer Webanwendung, als lokales Rechensystem oder als tragbares Gerät zur Überprüfung der Überspannungsableiter vor Ort ausgeführt sein.

Die beschriebenen Ausgestaltungen und Weiterbildungen lassen sich beliebig miteinander kombinieren.

Die beiliegenden Zeichnungen sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung.

Es zeigen:
- Fig. 1: schematisch den Ablauf eines Verfahrens gemäß einer Ausführungsform; und
- Fig. 2: schematisch den Ablauf eines Verfahrens gemäß einer weiteren Ausführungsform.

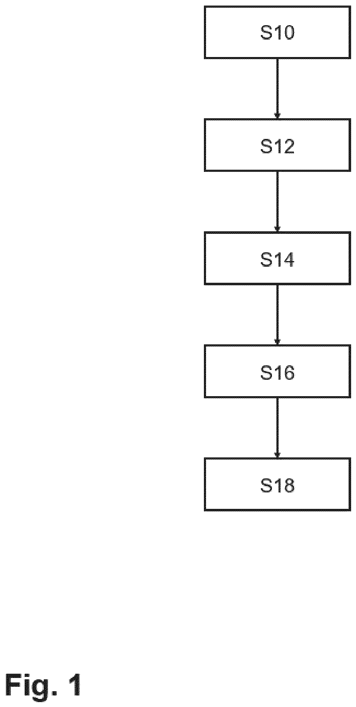

Fig. 1 zeigt schematisch einen vereinfachten Ablauf des Verfahrens gemäß einer Ausführungsform.

Das Verfahren beginnt in Schritt S10, indem die Messwerte eines Überspannungsableiters bereitgestellt werden. Die Messwerte können kontinuierlich erfasst und ausgewertet oder vorangehend gesammelt und gebündelt ausgewertet werden. Beispielsweise können die Messwerte über ein Netzwerk, insbesondere ein Funknetzwerk von den Überspannungsableitern an eine Datenverarbeitungsanlage übertragen werden. Die Datenverarbeitungsanlage kann bei dem Betreiber der energietechnischen Anlage oder beim Hersteller verortet sein. Die primären Messwerte sind Strommesswerte mit einer Auflösung weit unterhalb der Netzfrequenz. Diese primären Messwerte werden über eine hinreichend lange Zeit gesammelt, beispielsweise 10 Wellenzüge, und gespeichert. Die Gewinnung der primären Messwerte kann kontinuierlich erfolgen, bevorzugt ist aber, diese Werte in periodischen Abständen zu messen, so dass ein Satz von primären Messwerten etwa einmal pro Stunde oder einmal alle 15 Minuten erhalten wird.

Aus einem Satz der primären Messwerte wird dann, bevorzugt im Messgerät selbst, der Spitzenstrom, die dritte Harmonische des Leckstroms (im Folgenden der Einfachheit halber oft "Leckstrom" genannt) und ggf. weitere Kennwerte bzw. abgeleitete Messwerte erhalten. Wenn im Folgenden der Begriff Messwert verwendet wird, ist damit regelmäßig einer der abgeleiteten Messwerte gemeint, es sei denn, es würde ausdrücklich auf einen primären Messwert hingewiesen.

In einem zweiten Schritt S12 werden die bereitgestellten Messwerte standardisiert. Die Standardisierung dient dazu, die Messwerte des zu untersuchenden Überspannungsableiters mit der Gesamtheit der für das Training des Algorithmus des maschinellen Lernens verwendeten Überspannungsableiter vergleichbar zu machen. Hierbei werden die Messwerte um Effekte korrigiert, die sich aus der speziellen Konfiguration des analysierten Überspannungsableiter ergeben. Die Korrektur kann beispielsweise die Art des Überspannungsableiters, seinen Einsatz oder die ihn umgebende Infrastruktur berücksichtigen. Im Besonderen können die Netzspannung im Verhältnis zur Ableiter-Bemessungsspannung, das Verhältnis der Bemessungsspannung zur Referenzspannung des Überspannungsableiters, der verwendete Varistor-Typ, die Fertigungstoleranz im ZnO-Stapelprozess bei der Herstellung des Überspannungsableiters, die Erdungsbedingungen und/oder die kapazitiven Randbedingungen am Einsatzort berücksichtigt werden. Ferner können die Messwerte hinsichtlich des Gehäuses des Überspannungsableiters, bestehend aus Porzellan oder Kunststoff, des Schirmdesigns und/oder dem Einsatzort und seinen klimatischen Bedingungen standardisiert werden.

In Schritt S14 werden aus den standardisierten Messwerten Kenngrößen abgeleitet. Die Kenngrößen dienen dazu, den Zustand des Überspannungsableiters zu erkennen. Als Kenngröße können unterschiedliche Merkmale verwendet werden, die sich aus dem Verhalten des Überspannungsableiters ergeben. Insbesondere können der Leckstrom (Spitzenwert oder dritte Harmonische) als Messwert und daraus ermittelte Merkmale als Kenngrößen verwendet werden.

Ohne darauf beschränkt zu sein, können die Kenngrößen einen diskreten Spektralanteil 1/Tag im Spitzenstrom, einen diskreten Spektralanteil 2/Tag, die höheren Harmonischen der diskreten Spektralanteile, ein abfallender Trend (m_{f} < 0) im diskreten Frequenzspektrum des Spitzenstroms, das Signal-zu-Rausch-Verhältnis im Frequenzspektrum, ein ansteigender Trend (m_{f} > 0) im diskreten Frequenzspektrum, die Korrelation zwischen dem Spitzenstrom und dem resistiven Strom im Zeitbereich und/oder ein Trend m_{z} im Zeitbereich des Spitzenstroms und des Spitzenstroms umfassen.

In Schritt S16 wird ein Algorithmus des maschinellen Lernens verwendet, um einen Zustand des Überspannungsableiters zu ermitteln. Dazu werden die Kenngrößen als Eingangsgrößen in den Algorithmus des maschinellen Lernens eingegeben. Der Algorithmus des maschinellen Lernens wurde unter Verwendung von Trainingsdaten darauf trainiert, den Zustand eines Überspannungsableiters zu erkennen. Die Trainingsdaten umfassen die Kenngrößen von einer Mehrzahl von Überspannungsableitern in unterschiedlichen Situationen und mit unterschiedlichen Zuständen.

Mit der Zustandsermittlung kann insbesondere eine Klassifizierungsaufgabe verbunden sein, bei der der Algorithmus des maschinellen Lernens den Überspannungsableiter aufgrund seiner Kenngrößen einer von mehreren Klassen zuordnet, wobei jede Klasse für einen Zustand steht.

Wie die Zuordnung erfolgt, hängt vom gewählten Modell und dessen Architektur ab. Unterschiedliche Modelle sind unterschiedlich aufgebaut. Grundsätzlich kann jedes Modell verwendet werden, dass sich für Klassifikationsaufgaben eignet. Hierbei wird ein Clustering vorgenommen, da keine gelabelte Daten vorliegen. Als Ergebnisse ergibt sich die Gruppenbildungen, wobei anschließend weitere Verfahren (für die Klassifikation) angewendet werden können.

In einem letzten Schritt S18 wird der Zustand und die Ausprägung des Zustands mit einer entsprechende Handlungsempfehlung oder mit einem Alarm gemeldet.

In einer Ausführungsform kann der Überspannungsableiter mehreren Zuständen zugeordnet sein. Beispielsweise kann ein erster Zustand einen Verschmutzungsgrad und ein zweiter Zustand die Verfassung der Dichtungen im Überspannungsableiter kennzeichnen. Die Eigenschaften "Gehäuse verschmutzt/nicht verschmutzt" und "Dichtung intakt/nicht intakt" schließen einander nicht aus. Ferner können die Zustände als Parameter in einem Spektrum ausgegeben werden, sodass beispielsweise eine Quantifizierung einer Eigenschaft des Überspannungsableiters stattfindet.

Erfindungsgemäß kann auch aus der Zusammenschau der Messwerte oder Kenngrößen einer Gruppe von Überspannungsableitern, die in unmittelbarer Nachbarschaft angebracht und die jeweils einer der 3 Phasen des Netzes zugeordnet sind, zusätzliche Information gewonnen werden,

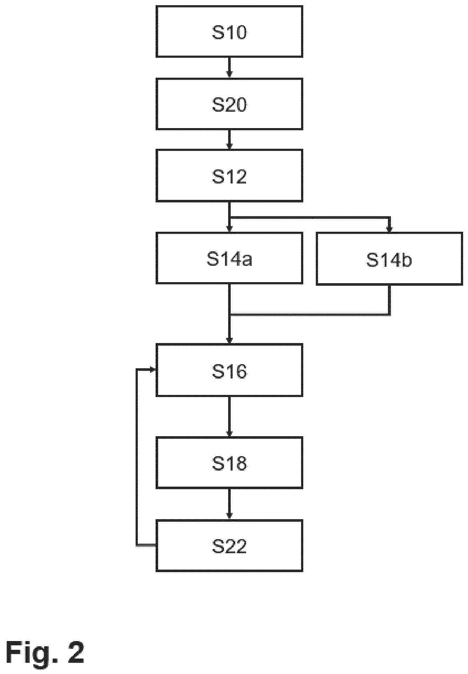

Figur 2 zeigt eine Abwandlung des Verfahrens aus Figur 1. Der in Figur 2 schematisch dargestellte Ablauf des Verfahrens gemäß einer weiteren Ausführungsform beginnt ebenfalls mit der Bereitstellung von abgeleiteten Messwerten eines Überspannungsableiters in Schritt S10.

Vor der Standardisierung werden die Messwerte in Schritt S20 vorverarbeitet. Die Vorverarbeitung kann insbesondere eine Segmentierung der Messwerte umfassen, um einzelne Signale zu isolieren. Aus einem gemessenen Leckstrom können beispielsweise ein Spitzenstrom und ein resistiver Strom ermittelt werden. Ferner können die Messwerte gefiltert werden, um beispielsweise das Rauschen des Messgeräts oder ein anderes signalfremdes Rauschen zu entfernen.

Nach dem Standardisieren in Schritt S12 werden die Kenngrößen in den Schritten S14a und S14b extrahiert. Dazu werden die standardisierten Messwerte in einen Frequenzraum transformiert. Die Kenngrößen können dann den Messwerten im Zeitraum in Schritt S14a und dem Frequenzspektrum in Schritt S14b entnommen werden.

Die Bestimmung des Zustands in den Schritten S16 und die Ausgabe eine Handlungsempfehlung in Schritt S18 können in dieser Ausführungsform wie für Figur 1 beschrieben verlaufen.

Im Anschluss an die Bewertung in Schritt S18 kann jedoch eine Validierung der Bewertung in Schritt S22 vorgenommen werden.

Die Bewertung kann beispielsweise dadurch validiert werden, dass bei einer durch die Bewertung begründeten Wartung des Überspannungsableiters geprüft wird, ob die dem Überspannungsableiter zugeordneten Zustände tatsächlich vorliegen. Beispielsweise kann der Grad der Verschmutzung des Gehäuses oder die Feuchtigkeit im Inneren des Überspannungsableiters bestimmt werden. Zusätzlich oder alternativ können Stichproben durchgeführt werden, um die Verarbeitung der Messwerte mit dem Algorithmus des maschinellen Lernens zu überprüfen.

Alternativ kann ein vom dem erfindungsgemäßen Verfahren zum Austausch bestimmter Überspannungsableiter an den Hersteller zurückgegeben werden, um einer genauen Untersuchung im Labor unterzogen zu werden.

Die Ergebnisse dieser Untersuchungen können dann zum Training des Systems zurückgespeilt werden.

Während derzeitige Überwachungsgeräte nur die primären Messwerte eines Überspannungsableiters benutzen, um einfaches "Rot-Gelb-Grün"-Signal auszugeben, erlaubt es die Erfindung durch den Einsatz des maschinellen Lernens und der Berücksichtigung einer großen Zahl von Messdaten unterschiedlichster Überspannungsableite in unterschiedlichsten Umgebungen eine wesentlich genauere und zuverlässigere Aussage über den Zustand jedes einzelnen Überspannungsableiters zu machen, ohne dass ein Fachmann selbst eine komplizierte Einzelauswertung vornehmen müsste.

### Bezugszeichen

- S10: Bereitstellen von Messwerten
- S12: Standardisieren der Messwerte
- S14: Extrahieren von Kenngrößen
- S14a: Extrahieren von Kenngrößen aus dem Zeitraum
- S14b: Extrahieren von Kenngrößen aus dem Frequenzspektrum
- S16: Ermitteln eines Zustands
- S18: Ableiten einer Handlungsempfehlung
- S20: Vorverarbeiten der Messwerte
- S22: Validierung der Bewertung

## Patentansprüche

1. Computerimplementiertes Verfahren zur Bewertung eines Verhaltens eines Überspannungsableiters, wobei das Verfahren die folgenden Schritte umfasst:
Bereitstellen von Messwerten (S10) eines oder mehrerer Überspannungsableiter;
Standardisieren der bereitgestellten Messwerte (S12);
Extrahieren von Kenngrößen (S14) zur Charakterisierung zumindest eines Überspannungsableiters aus den standardisierten Messwerten;
Ermitteln eines Zustands des zumindest einen Überspannungsableiters (S16) unter Verwendung eines Algorithmus des maschinellen Lernens;
Ausgeben einer Handlungsempfehlung (S18) für den Betrieb des zumindest einen Überspannungsableiters.

2. Computerimplementiertes Verfahren nach Anspruch 1, wobei dem Standardisieren der bereitgestellten Messwerte (S12) ein Glätten der bereitgestellten Messwerte vorausgeht.

3. Computerimplementiertes Verfahren nach einem der vorangegangenen Ansprüche, wobei dem Standardisieren der bereitgestellten Messwerte (S12) ein Entfernen der Aus-Zustände aus den bereitgestellten Messwerten vorausgeht.

4. Computerimplementiertes Verfahren nach einem der vorangegangenen Ansprüche, wobei die Messwerte durch Messen des Leckstroms im Überspannungsableiter erfasst werden, wobei aus dem Leckstrom ein Spitzenstrom und ein resistiver Leckstrom ermittelt werden.

5. Computerimplementiertes Verfahren nach einem der vorangegangenen Ansprüche, wobei die Messwerte im Betrieb des Überspannungsableiters ermittelt werden.

6. Computerimplementiertes Verfahren nach einem der vorangegangenen Ansprüche, wobei das Extrahieren der Kenngrößen (S14) eine Transformation der standardisierten Messwerte in ein Frequenzspektrum umfasst und wobei die Kenngrößen diskrete Spektralanteile aus dem Frequenzspektrum und/oder einen Trend im Frequenzspektrum des Spitzenstroms umfassen.

7. Computerimplementiertes Verfahren nach Anspruch 6, wobei die Kenngrößen ferner ein Signal-zu-Rauschverhältnis im Frequenzspektrum, insbesondere in einem definierten Abschnitt des Frequenzspektrums, umfassen.

8. Computerimplementiertes Verfahren nach einem der vorangegangenen Ansprüche, wobei die Kenngrößen ferner einen Korrelationswert zwischen dem Spitzenstrom und dem resistiven Strom im Zeitbereich umfassen.

9. Computerprogramm mit Programmcode, um ein Verfahren nach einem der vorangegangenen Ansprüche auszuführen, wenn das Computerprogramm auf einem Computer ausgeführt wird.

10. System zur Ausgabe einer Handlungsempfehlung für den Betrieb eines Überspannungsableiters, wobei das System ausgebildet ist, ein Verfahren nach einem der Ansprüche 1 bis 8 auszuführen
